# EUROPÄISCHE PATENTSCHRIFT

(11) **EP 0 695 250 B1**
(45) Veröffentlichungstag und Bekanntmachung des Hinweises auf die Patenterteilung: **11.06.1997**
(21) Anmeldenummer: 94911160.3
(22) Anmeldetag: 12.03.1994
(51) Int. Cl.: B60T 8/88

(54) **SCHALTUNGSANORDNUNG ZUR WARNLAMPEN-ANSTEUERUNG**
CIRCUIT FOR TRIGGERING WARNING LAMPS
CIRCUIT POUR COMMANDE D'ALLUMAGE DE LAMPES TEMOINS

(30) Priorität: 31.03.1993 DE 4310530
(43) Veröffentlichungstag der Anmeldung: 07.02.1996
(73) Patentinhaber: ITT Automotive Europe GmbH, 60488 Frankfurt (DE)
(72) Erfinder: ZYDEK, Michael, D-35428 Langgöns (DE); FEY, Wolfgang, D-65527 Niedernhausen (DE); ENGELMANN, Mario, D-61449 Steinbach (DE)
(74) Vertreter: Blum, Klaus-Dieter, Dipl.-Ing.
(86) Internationale Anmeldenummer: EP9400771
(87) Internationale Veröffentlichungsnummer: WO9422700

(56) Entgegenhaltungen:
- DE-A- 4 037 175
- US-A- 4 016 457
- US-A- 4 709 223

## Beschreibung

Die Erfindung bezieht sich auf eine Schaltungsanordnung zur Ansteuerung der Warnlampe einer Kraftfahrzeug-Bremsanlage, die zur Blockierschutz- und/oder Antriebsschlupfregelung einen elektronischen Regler, welcher an mehrere Versorgungsspannungen angeschlossen ist, aufweist, mit einem Leistungstreiber, über den beim Vorliegen eines durch eine Fehlfunktion des Reglers ausgelösten Überwachungssignals der Warnlampestrom fließt, und mit einer Zusatzschaltung, die bei Absinken einer der Versorgungsspannungen unter einen Schwellwert den Leistungstreiber ansteuert.

Eine derartige Schaltungsanordnung ist bereits aus der DE 40 37 175 A1 bekannt. Es handelt sich dabei um einen Regler für eine blockiergeschützte Bremsanlage (ABS), die eine Zusatz schaltung in Form eines Spannungsüberwachungkreises aufweist. Beim Absinken der Versorgungsspannung unter einem Schwellwert steuert der Überwachungskreis eine Treiberstufe an, die einen Transistor enthält, welcher, sobald er durchgesteuert ist, eine Warnlampe zum Aufleuchten bringt. Es ist nicht ersichtlich, auf welche Weise bei Ausfall der Versorgungsspannung die Treiberstufe zur Einschaltung der Lampe angesteuert werden könnte.

Bei Bremsanlagen mit elektronischer Blockierschutz- oder Antriebsschlupfregelung wird bekanntlich ein Ausschalten der Regelung beim Auftreten von Fehlern verlangt oder ist sogar gesetzlich vorgeschrieben, um im Fehlerfall zumindest die ungeregelte Bremsenfunktion sicherzustellen. Mit Hilfe einer Warnlampe wird dabei das Erkennen eines Fehlers optisch signalisiert. Bekannte Bremsanlagen dieser Art enthalten ein mechanisches Relais, nämlich ein sogenanntes Hauptrelais, mit einem Arbeitskontakt, über den der Regler der Bremsanlage ein- und ausgeschaltet werden kann. Dieses Relais besitzt auch einen Ruhekontakt, über den bei Abfall des Relais die Warnlampe eingeschaltet wird.

Wird das mechanische Relais durch ein Halbleiterrelais ersetzt, was aus verschiedenen Gründen vorteilhaft ist, tritt die Schwierigkeit auf, daß beim Ausfall der Stromversorgung keine mit dem Ruhekontakt des mechanischen Relais vergleichbare Möglichkeit zur Einschaltung der Warnlampe besteht. Das Aufleuchten der Warnlampe bei jeglicher Abschaltung der Regelung ist jedoch ein wichtiger Sicherheitsbeitrag und vielfach auch eine gesetzliche Forderung.

Der Erfindung liegt nun die Aufgabe zugrunde, auf einfachem Wege und ohne nennenswerte Erhöhung des Herstellungsaufwandes die Einschaltung der Warnlampe sicherzustellen, und zwar auch dann, wenn der Regler über ein Halbleiterrelais mit Strom versorgt wird; bei Verwendung eines mechanischen Relais wäre es von Vorteil, wenn man auf den Ruhekontakt zur Einschaltung der Warnlampe und auf die erforderlichen Maßnahmen zur Überwachung der Funktion dieses Ruhekontaktes verzichten könnte.

Es hat sich gezeigt, daß diese Aufgabe durch die im beigefügten Anspruch 1 beschriebene Weiterbildung einer Schaltungsandnung zur Warnlampen-Ansteuerung gelöst werden kann. Vorteilhafte Ausführungsarten der erfindungsgemäßen Schaltungsanordnung sind in den Unteransprüchen beschrieben.

Erfindungsgemäß wird also die Ansteuerungsschaltung der Warnlampe durch eine Zusatzschaltung ergänzt, die beim Vorhandensein der Versorgungsspannungen keinerlei Einfluß auf die Warnlampen-Ansteuerung ausübt und die, sobald eine oder alle Versorgungsspannungen ausfallen, selbstleitend wird und daher den über die Warnlampe zur Masse führende Stromweg schließt.

Die Zusatzschaltung läßt sich im wesentlichen durch wenige leistungsarme Transistoren, die durch Modifikation der integrierten Warnlampen-Treiberschaltung realisiert werden können, aufbauen. Der dadurch erforderliche zusätzliche Herstellungsaufwand ist minimal.

Weitere Merkmale, Vorteile und Anwendungsmöglichkeiten gehen aus der folgenden Beschreibung von Details der Erfindung anhand der beigefügten Abbildungen hervor.

Es zeigen in schematischer Vereinfachung
- Fig. 1: eine Schaltungsanordnung zur Warnlampen-Ansteuerung mit symbolischer Darstellung der verschiedenen Anschlüsse und
- Fig. 2: in vergrößerter Darstellung Details der eigentlichen Warnlampen-Ansteuerungsschaltung nach Fig. 1.

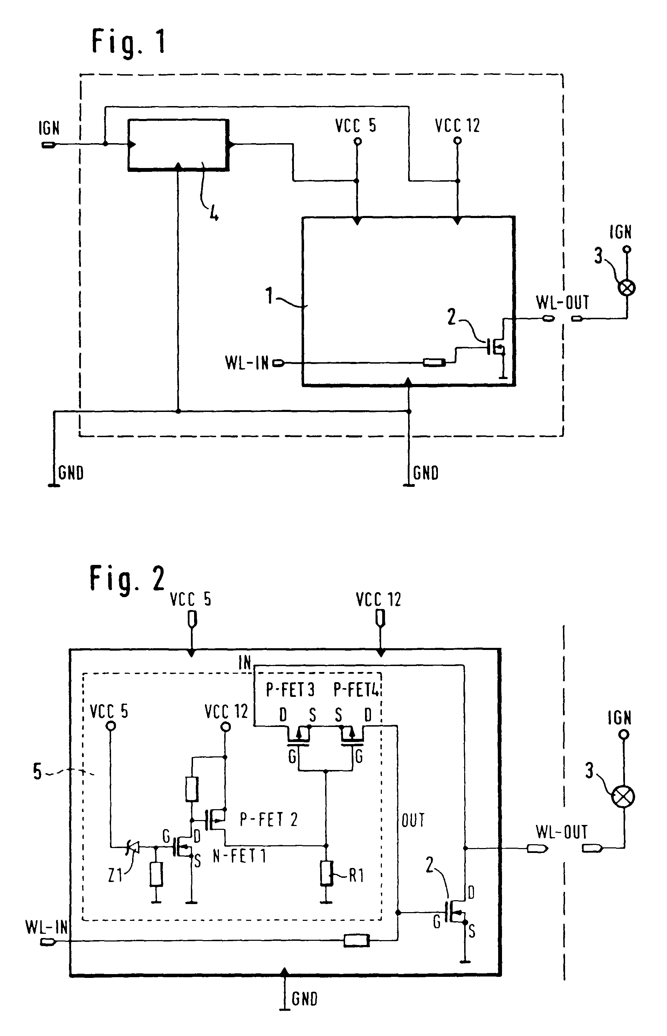

In Fig. 1 ist ein Baustein 1, der die erfindungsgemäße Schaltungsanordnung zur Warnlampen-Ansteuerung darstellt, wiedergegeben. Es handelt sich dabei um eine integrierte Schaltung, die unter anderem einen Leistungstransistor oder Leistungstreiber 2 enthält, über den, wenn ein Überwachungssignal bzw. ein auf einen Fehler hinweisendes Signal vorhanden ist, der Strom zum Aufleuchten der Warnlampe 3 geleitet wird. Als Leistungstreiber 2 kann beispielsweise ein Leistungs-FET verwendet werden. Das Überwachungssignal bzw. Signal zur Einschaltung des Transistors 2 wird der Schaltungsanordnung 1 über den Warnlampeneingang WL-IN zugeführt.

Die Warnlampenschaltung 1 wird im Ausführungsbeispiel nach Fig. 1 mit zwei Spannungen unterschiedlicher Höhe versorgt. Am Eingang VCC5 liegt im vorliegenden Beispiel eine durch einen Spannungsregler stabilisierte Spannung von 5 V, während an dem zweiten Versorgungseingang VCC12 in diesem Fall direkt die Batteriespannung von z. B. 12 V des Fahrzeugs anliegt. Die Batteriespannung wird über einen Zündkontaktanschluß IGN zugeführt. Über einen Anschluß WL-OUT wird die Warnlampe 3 angeschlossen. Die Stromzufuhr zur Warnlampe erfolgt ebenfalls über den Zündschalter IGN, an dem die Batteriespannung anliegt. Die Schaltungsanordnung 1 ist natürlich auch an Masse GND angeschlossen.

Ein integrierter Bestandteil des Bausteins 1, der die Warnlampen-Ansteuerungsschaltung enthält, ist die erfindungsgemäße Zusatzschaltung 5, die im Detail in Fig. 2 dargestellt ist. Die gestrichelte Umrahmung symbolisiert die Zusammengehörigkeit der dargestellten elektronischen Bauteile. Von der Warnlampen-Ansteuerungsschaltung (1) ist auch in Fig. 2 nur der Leistungstreiber 2 wiedergegeben.

Die Zusatz schaltung 5 enthält 2 antiseriell zusammengeschaltete p-Kanal-Feldeffekttransistoren P-FET3 und P-FET4. Solche Transistoren sind selbstsperrend, werden jedoch erfindungsgemäß durch den Anschluß der Gateelektroden G der Transistoren P-FET3 und P-FET4 an Masse GND über einen hochohmigen Widerstand R1 zu einer selbstleitenden Transistorschaltung ergänzt.

Bei ordnungsgemäßer Anschaltung der beiden Versorgungsspannungen VCC5 und VCC12 liegen die beiden Gate-Anschlüsse der Transistoren P-FET3 und P-FET4 (nahezu) auf dem Potential des Spannungsanschlusses VCC12. Die beiden in Kaskade geschalteten Transistoren N-FET1 und P-FET2, über die die beiden antiseriell geschalteten Transistoren P-FET3 und P-FET4 angesteuert werden, sind nämlich, wenn sowohl die Versorgungsspannung VCC5 als auch die Versorgungsspannung VCC12 anliegen, "ein"-geschaltet, so daß das Potential am Anschluß VCC12 mit dem Potential an den Gate-Elektroden G der antiseriellen Transistoren P-FET3 und P-FET4 praktisch übereinstimmt.

Fällt eine der Spannungen VCC5 oder VCC12 aus, wird der Stromfluß über den jeweiligen Transistor N-FET1 bzw. P-FET2 gesperrt, so daß nunmehr R1 das Potential an den Gate-Elektroden der antiseriellen Transistoren P-FET3 und P-FET4 bestimmt; dadurch werden die Transistoren P-FET3,P-FET4 "eingeschaltet". Die Gate-Schwellenspannung zum Einschalten des Leistungstransistors 2 wird überschritten.

Über die antiseriellen Transistoren P-FET3 und P-FET4 stellt sich nunmehr eine Spannung an der Gate-Elektrode des Leistungstreibers 2 ein, weil über den Anschluß WL-OUT, die Warnlampe 3 und über IGN eine Verbindung zur Fahrzeugbatterie besteht. Der dadurch auf Durchlaß geschaltete Leistungstransistor 2 bringt schließlich die Warnlampe 3 zum Aufleuchten.

Eine Zenerdiode Z1 im Anschlußweg des Transistors N-FET1 an die Spannungsquelle VCC5 hat zur Folge, daß ein Fehler bereits dann signalisiert wird, wenn die Spannung VCC5 einen von den Zenerspannung und der Gate-Schwellenspannung des Transistors N-FET1 abhängigen Schwellwert unterschreitet.

Die Schaltungsanordnung nach der Erfindung hat den in der Praxis sehr wichtigen Vorteil, daß auch bei Ausfall der Versorgungsspannungen VCC5 und/oder VCC12 die Warnlampe 3 unmittelbar über den auf Durchlaß geschalteten Leistungstransistor 2 eingeschaltet wird. Es tritt kein zusätzlicher Spannungsabfall in der (stromlosen) Zusatzschaltung bzw. Ansteuerschaltung des Transistors 2 auf. Die Helligkeit der Warnlampe 3, die bei relativ geringer Batteriespannung kritisch ist, wird nicht verringert.

## Patentansprüche

1. Schaltungsanordnung zur Ansteuerung der Warnlampe (3) einer Kraftfahrzeug-Bremsanlage, die zur Blockierschutz- und/oder Antriebsschlupfregelung einen elektronischen Regler, welcher an mehrere Versorgungsspannungen angeschlossen ist, aufweist,
mit einem Leistungstreiber (2), über den beim Vorliegen eines durch eine Fehlfunktion des Reglers ausgelösten Überwachungssignals der Warnlampenstrom fließt, und mit einer Zusatzschaltung (5), die bei Absinken einer der Versorgungsspannungen unter einen Schwellwert den Leistungstreiber (2) ansteuert, dadurch **gekennzeichnet**, daß die Zusatzschaltung (5) eine selbstleitende Transistorschaltung (P-FET3,P-FET4,R1) mit einer an die Versorgungsspannungen (VCC5,VCC12) des Reglers angeschlossenen Ansteuerschaltung enthält, welche, solange alle Versorgungsspannungen (VCC5,VCC12) in Ordnung sind, die Transistorschaltung (P-FET3,P-FET4,R1) gesperrt hält und die bei Ausfall oder Absinken einer der Versorgungsspannungen (VCC5,VCC12) unter den Schwellwert einen über die Warnlampe (3) zu dem Steueranschluß (G) des Leistungstreibers (2) führenden, den Leistungstreiber (2) ansteuernden bzw. einschaltenden Stromfluß hervorruft.

2. Schaltungsanordnung nach Anspruch 1, dadurch **gekennzeichnet**, daß die selbstleitende Transistorschaltung (P-FET3,P-FET4,R1) aus zwei antiseriell geschalteten p-Kanal-Feldeffekt-Transitoren besteht, deren Gateanschlüsse (G) miteinander verbunden, an den Ausgang der Ansteuerschaltung angeschaltet und über einen hochohmigen Widerstand (R1) an Masse (GND) angeschlossen sind.

3. Schaltungsanordnung nach Anspruch 2, dadurch **gekennzeichnet**, daß als Leistungstreiber (2) ein Feldeffekttransistor vorgesehen ist, dessen Drain-Elektrode (D) zu der Warnlampe (3) führt, und daß die aus den beiden Drain-Source-Strecken der antiseriell geschalteten Transistoren (P-FET3,P-FET4) der selbstleitenden Transistorschaltung gebildete Strecke der Drain-Gate-Strecke des Leistungstreibers (2) parallel geschaltet ist.

4. Schaltungsanordnung nach einem oder mehreren der Ansprüche 1 - 3, dadurch **gekennzeichnet**, daß die Zusatzschaltung (5) als Bestandteil einer integrierten Schaltung, die den Leistungstreiber (2) enthält, ausgebildet ist.

## Claims

1. Circuit for triggering the warning lamp (3) of an automotive vehicle brake system which, for anti-lock and/or traction slip control, includes an electronic controller connected to a plurality of supply voltages, a power driver (2) through which the warning lamp current flows in the presence of a monitoring signal initiated by malfunction of the controller, and an additional circuit (5) triggering the power driver (2) when any one of the supply voltages drops below a threshold value,
**characterized** in that the additional circuit (5) includes a self-conductive transistor circuit (P-FET3, P-FET4, R1) with a triggering circuit connected to the supply voltages (VCC5, VCC12) of the controller which, as long as all supply voltages (VCC5, VCC12) are sufficient, keeps the transistor circuit (P-FET3, P-FET4, R1) blocked and, on failure or decline of any of the supply voltages (VCC5, VCC12) below a threshold value, causes current to flow by way of the warning lamp (3) to the control terminal (G) of the power driver (2) to trigger or switch on the power driver (2).

2. A circuit as claimed in claim 1,
**characterized** in that the self-conductive transistor circuit (P-FET3, P-FET4, R1) includes two serially connected, oppositely directed p-channel field effect transistors, the gate terminals (G) of which are interconnected, connected to the outlet of the triggering circuit, and connected to ground (GND) by way of a high-ohmic resistor (R1).

3. A circuit as claimed in claim 2,
**characterized** in that the power driver (2) is a field effect transistor having its drain electrode (D) extend to the warning lamp (3), and in that the path formed of the two drain source paths of the serially connected, oppositely directed transistors (P-FET3, P-FET4, R1) of the self-conductive transistor circuit is connected in parallel to the drain gate path of the power driver (2).

4. A circuit as claimed in any one or more of claims 1 - 3,
**characterized** in that the additional circuit (5) is a component of an integrated circuit which comprises the power driver (2).

## Revendications

1. Agencement de circuit, servant à commander la lampe témoin (3) d'un système de freinage pour véhicule automobile comportant, pour la régulation antiblocage et/ou du glissement de traction, un régulateur électronique raccordé à plusieurs tensions d'alimentation, qui comprend un étage excitateur de puissance (2), par lequel le courant de la lampe témoin passe lorsqu'il se présente un signal de surveillance déclenché par un fonctionnement défectueux du régulateur, et un circuit supplémentaire (5) qui commande l'étage excitateur de puissance (2) lorsque l'une des tensions d'alimentation passe au-dessous d'une valeur de seuil, caractérisé en ce que le circuit supplémentaire (5) contient un circuit de transistors autoconducteur (P-FET3, P-FET4, R1) comportant un circuit de commande, connecté aux tensions d'alimentation (VCC5, VCC12) du régulateur, qui maintient le circuit de transistors (P-FET3, P-FET4, R1) bloqué aussi longtemps que toutes les tensions d'alimentation (VCC5, VCC12) sont en ordre et qui, lorsque l'une des tensions d'alimentation (VCC5, VCC12) fait défaut ou descend au-dessous de la valeur de seuil, provoque un passage de courant qui se dirige vers la borne de commande (G) de l'étage excitateur de puissance (2) en passant par la lampe témoin (3) et commande, plus précisément rend passant, l'étage excitateur de puissance (2).

2. Agencement de circuit selon la revendication 1, caractérisé en ce que le circuit de transistors autoconducteur (P-FET3, P-FET4, R1) est constitué de deux transistors à effet de champ à canal p à montage anti-série dont les bornes de grille (G) sont reliées l'une à l'autre, sont connectées à la sortie du circuit de commande et sont raccordées à la masse (GND) par l'intermédiaire d'une résistance (R1) à haute impédance.

3. Agencement de circuit selon la revendication 2, caractérisé en ce qu'en tant qu'étage excitateur de puissance (2), il est prévu un transistor à effet de champ dont l'électrode de drain (D) mène à la lampe témoin (3) et en ce que le chemin formé par les deux chemins drain-source des transistors (P-FET3, P-FET4) à montage anti-série du circuit de transistors autoconducteur est connecté en parallèle au chemin drain-grille de l'étage excitateur de puissance (2).

4. Agencement de circuit selon une ou plusieurs des revendications 1-3, caractérisé en ce que le circuit supplémentaire (5) est réalisé sous forme d'une partie constitutive d'un circuit intégré qui contient l'étage excitateur de puissance (2).
